# EUROPEAN PATENT SPECIFICATION

(11) **EP 2 726 640 B1**
(45) Date of publication and mention of the grant of the patent: **08.12.2021**
(21) Application number: 11868729.2
(22) Date of filing: 30.06.2011
(51) Int. Cl.: C23C 14/06, C23C 14/35, G01T 3/00, G01T 3/08

(54) **A METHOD FOR PRODUCING A NEUTRON DETECTOR COMPONENT COMPRISING A BORON CARBIDE LAYER FOR USE IN A NEUTRON DETECTING DEVICE**
VERFAHREN ZUR HERSTELLUNG EINES NEUTRONENDETEKTORBAUELEMENTS MIT EINER BORCARBIDSCHICHT ZUR VERWENDUNG BEI EINEM NEUTRONENDETEKTOR
PROCÉDÉ PERMETTANT DE PRODUIRE UN COMPOSANT DÉTECTEUR DE NEUTRONS QUI COMPREND UNE COUCHE DE CARBURE DE BORE DESTINÉE À ÊTRE UTILISÉE DANS UN DISPOSITIF DE DÉTECTION DE NEUTRONS

(43) Date of publication of application: 07.05.2014
(73) Proprietor: European Spallation Source ERIC, 221 00 Lund (SE); Hultman, Lars, 589 31 Linköping (SE); Birch, Jens, 582 16 Linköping (SE)
(72) Inventor: HULTMAN, Lars, S-589 31 Linköping (SE); BIRCH, Jens, S-582 16 Linköping (SE); HÖGLUND, Carina, S-583 33 Linköping (SE)
(74) Representative: AWA Sweden AB
(86) International application number: PCT/SE2011/050891
(87) International publication number: WO 2013/002697

(56) References cited:
- EP-A1- 2 144 089
- US-A- 4 587 088
- US-A1- 2005 258 373
- US-A1- 2005 258 373
- US-A1- 2010 314 549
- US-B1- 6 771 730
- RUQIANG BAO ET AL: "Short range order structure of amorphous B4C boron carbide thin films", JOURNAL OF MATERIALS SCIENCE, vol. 46, no. 11, 11 February 2011 (2011-02-11), pages 3952-3959, XP055162653, ISSN: 0022-2461, DOI: 10.1007/s10853-011-5320-3
- SHIN-ICHI AOQUI ET AL.: 'Preparation of boron carbide thin film by pulsed KrF excimer laser' THIN SOLID FILMS vol. 407, 2002, pages 126 - 131, XP004352909
- DONALD M. MATTOX HANDBOOK OF PHYSICAL VAPOR DEPOSITION (PVD) PROCESSING 1998, pages 636 - 638, 681-682, XP008172825
- RUQIANG BAO ET AL.: 'Charge carrier lifetime in boron carbide thin films' APPL. PHYS. LETT. vol. 98, 11 May 2011, page 192106, XP012140623
- HÖGLUND CARINA ET AL: "BC thin films for neutron detection", JOURNAL OF APPLIED PHYSICS, AMERICAN INSTITUTE OF PHYSICS, US, vol. 111, no. 10 15 May 2012 (2012-05-15), pages 104908-104908, XP012157584, ISSN: 0021-8979, DOI: 10.1063/1.4718573 Retrieved from the Internet: URL:https://aip.scitation.org/doi/10.1063/ 1.4718573 [retrieved on 2012-05-23]

## Description

### Technical field

The present disclosure relates to a method for producing a neutron detector component comprising a neutron detecting boron carbide layer comprising boron-10 arranged on a substantially neutron transparent substrate. The disclosure also relates to a neutron detector component for use in a neutron detector, the use of such a neutron detector component for neutron detection, and a neutron detecting device comprising a plurality of neutron detector components arranged as a stack.

### Technical background

Due to the approaching very limited availability of ³He and unaffordable prices of the same, new kinds of neutron detectors not based on ³He, are urgently needed, especially for large area neutron detector applications. One possible replacement for ³He for neutron detection is the boron isotope ¹⁰B. ¹⁰B has a relatively high neutron absorption cross section, resulting in an absorption efficiency of 70% compared to ³He, at a neutron wavelength of 1.8 Å. Naturally occurring boron contains 20% of ¹⁰B, but due to the almost 10% mass difference to the other boron isotope, ¹¹B, the isotope separation is relatively simple.

Use of ¹⁰B in neutron detectors is known both in the scintillator, the gas, and the conversion layer varieties.

In US 6,771,730 a semiconductor neutron detector is shown having a boron carbide (B₄C) semiconducting layer, the B₄C layer containing ¹⁰B. The ¹⁰B₄C layer was deposited on doped silicon using plasma-enhanced chemical vapor deposition (PECVD). Synthesis of semiconducting B₄C may not be possible using other methods. In US 2005/258373 A1 another neutron detector having a boron carbide layer containing ¹⁰B is realized.

However, CVD techniques are in general, due to the use of gaseous materials, associated with process risks and also high material costs.

### Summary of the invention

Although the theoretical neutron detection efficiency would be higher with pure boron layers comprising boron-10 (¹⁰B), layers of boron carbide comprising boron-10 are preferred for stability reasons, both from a mechanical and contamination point of view. Physical vapor deposition (PVD) is associated with less process risk and lower material costs than CVD. However, when attempting to use PVD for producing layers of boron carbide comprising boron-10, other problems arise. For example, when a neutron detecting boron carbide layer comprising boron-10 is provided by direct use of conventional PVD, adhesion to the underlying substrate typically become lower than desirable, causing the layer to spall off or hindering formation of a continuous film. This may become a problem in particular for layer thicknesses in the micrometer range, which thicknesses typically are desirable to be able reach for neutron detection ability reasons, and when temperature sensitive substrates are used, such as of aluminum, which often is a material desirable to use as substrate.

Hence, in view of the above, one object of this disclosure is to overcome or at least alleviate problems in the prior art, or to at least present an alternative solution. A specific object is to present a method for producing neutron detector components based on PVD, where the neutron detector comprises a neutron detecting boron carbide layer comprising boron-10 arranged on a substantially neutron transparent substrate. Further objects are to present a neutron detector component for use in a neutron detector, use of such a neutron detector component for neutron detection and a neutron detecting device comprising a plurality of neutron detector components arranged as a stack.

The invention is defined by the appended independent claims. Preferred embodiments are set forth in the dependent claims and in the following description and drawings.

According to a first aspect of the present invention, these and other objects are achieved through a method for producing a neutron detector component comprising a neutron detecting boron carbide layer comprising boron-10 arranged on a substantially neutron transparent substrate, the method comprising: placing the substantially neutron transparent substrate and at least one source of coating material comprising carbon and boron-10 inside a coating chamber, evacuating the coating chamber to a pressure that is at most 6 mPa and heating at least a coating surface of the substantially neutron transparent substrate in the coating chamber to an elevated temperature that is at least 300°C to about 660°C, starting to coat the neutron detecting boron carbide layer comprising boron-10 on the substantially neutron transparent substrate by means of physical vapor deposition in the form of magnetron sputtering using the at least one source of coating material when said pressure and said elevated temperature are reached, and coating the neutron detecting boron carbide layer comprising boron-10 to a desired thickness, wherein the boron content ranges between 70 at.% and 85 at.% of the total number of boron and carbon atoms in the boron carbide layer, disregarding impurities, and wherein the boron-10 content of the neutron detecting boron carbide layer is at least about 60 at.%.

By "boron-10" is here meant the boron isotope ¹⁰B.

By "substantially neutron transparent substrate" is here meant a substrate that is made of such material and has such thickness that the substrate absorbs a number of neutrons which is less than 10% of the number of neutrons absorbed in the neutron detecting boron carbide layer, that is, has 10% or less neutron absorption than the neutron detecting boron carbide layer to be provided on the substrate.

It is implied that any heating of the substantially neutron transparent substrate is made to a temperature that is below the melting temperature of the substrate.

It should be noted that presentational order of the steps of the method should as such not be construed as limiting. Steps that are independent of each other may be performed in different order and/or may be partly or wholly overlapping. For example may the step of evacuating the coating chamber overlap the step of heating at least a coating surface of the substantially neutron transparent substrate.

As confirmed by experiments, the method enables improved adhesion of the boron carbide layer to the substantially neutron transparent substrate, thereby, in practice, allowing PVD to be used to provide boron-10 based neutron detecting layers in the micrometer range and on aluminum substrates. Although there is no wish to be bound by a particular explanation of underlying reasons, it is believed that one reason for poor adhesion is presence of contaminants in the boron carbide layer and on the substrate surface, which to a great extent are removed by the method. Additionally, there is increased risk for the boron carbide layer to spall off from the substrate with increasing stresses in the coating. The present method enables use of lower temperatures during coating, compared to conventional methods, which reduces such stresses in the boron carbide layer. Moreover, presence of contaminants in the boron carbide layer is also related to a lowered neutron detection efficiency of the boron carbide layer. A further advantage of the method is therefore also that it enables improved neutron detection efficiency.

The method may further comprise heating of at least a coating surface of the substantially neutron transparent substrate during the coating of the neutron detecting boron carbide layer.

The heating of at least a coating surface of the substantially neutron transparent substrate during the coating of the neutron detecting boron carbide layer may comprise heating to at least said elevated temperature.

The heating of at least a coating surface of the substantially neutron transparent substrate may comprise specific heating thereof.

By "specific heating" of at least a coating surface of the substantially neutron transparent substrate is here meant that heating is specifically directed for heating the substrate and not only what happen to result from the PVD process as such. The specific heating may e.g. be accomplished through direct heating of the substrate by e.g. supplying high electric current through the substrate, by indirect heating through e.g. radiation from a heating element specifically arranged to heat the substrate, and/or by heating of the substrate through utilization of energized species.

The substantially neutron transparent substrate may be a temperature sensitive substrate having a melting temperature that is at most about 660°C.

The method may further comprise: removing contaminants from the coating chamber with the substantially neutron transparent substrate and the source of coating material placed inside, prior to and/or during the evacuating of the coating chamber.

By "contaminant" is here generally meant any substance that is undesirably present or present at an undesirable amount in the coating chamber and that, if present during production, would have a detrimental effect on the resulting product. Contaminants typically involve the elements H, C, N, O, Ar, Ne or Kr, and compounds comprised of these elements, for example H₂O, OH, O₂, H₂, CH₄, N₂, CO₂, which typically occur bound to the walls of the coating chamber and/or to the substrate and/or are present at or in the source of coating material and/or are present in gases used in the PVD process.

By "removing contaminants from the coating chamber" is meant to include removal of contaminants that may be present anywhere inside the chamber, including contaminants bound to the walls of the coating chamber, and/or contaminants present at/in the source of coating material, and/or contaminants bound to or present at/in the substantially neutron transparent substrate.

The step of removing contaminants from the coating chamber may comprise heating and degassing of the coating chamber, while keeping the temperature of the substantially neutron transparent substrate below its melting temperature.

The removing of contaminants from the coating chamber may be performed during the evacuating of the coating chamber.

The heating of the coating chamber may comprise using heat from the heating of at least a coating surface of the substantially neutron transparent substrate.

The heating of the coating chamber may comprise using another separate source of heat than is used for the heating of at least a coating surface of the substantially neutron transparent substrate.

The heating of the coating chamber may comprise heating thereof to at least 100°C, or at least 200°C, or at least 300°C, or at least 400°C, or at least 500°C, or at least 600°C.

The removing of contaminants from the coating chamber may include removal of H₂O contaminants.

H₂O contaminants may be removed using a method directed specifically at reducing H₂O contaminants and may be selected from the group consisting of electron beam, infrared radiation, ultraviolet light and visible light irradiation, ion irradiation, contact with a resistive heating element, or a combination of any of these methods.

The temperature of at least a coating surface of the substantially neutron transparent substrate may vary during the coating process, preferably above the elevated temperature, but lower temperatures may be allowed as well. However, the temperature of the substrate should not be significantly below the elevated temperature and/or preferably only below the elevated temperature during a minor part of the coating process.

Coating at higher temperatures, preferably as high as possible below the melting temperature of the substrate, may result in better adhesion of the neutron detecting boron carbide layer to the substantially neutron transparent substrate and further reduce the amount of contaminants in the layer.

The pressure may be at most 3 mPa, preferably at most 1.5 mPa, or more preferably at most 0.75 mPa.

The method may comprise coating of the substantially neutron transparent substrate on opposing coating surfaces.

Although two-sided coatings may be desirable and advantageous for many applications, coating may be performed on only one surface as well.

The substantially neutron transparent substrate may be electrically conducting.

In the nuclear reaction between incident neutrons and ¹⁰B in the neutron detecting boron carbide layer: ¹⁰B + n → ⁷Li + ⁴He + 2.3 MeV, the ⁷Li and ⁴He isotopes leave the neutron detecting layer and may be detected with both temporal and spatial resolution in a detecting gas. Upon leaving, the neutron detecting layer is left with a negative net charge which may be compensated for by conducting away electrons from the boron carbide layer through the electrically conducting substantially neutron transparent substrate.

The substantially neutron transparent substrate may comprise aluminum or aluminum alloys. Such an alloy is for example a Si-AI alloy.

The neutron detecting boron carbide layer may be electrically conducting.

The conductivity of the neutron detecting boron carbide layer should be sufficient for neutralizing the negative net charge in the boron carbide layer formed as a consequence of charged particles leaving the surface of the neutron detecting layer upon the reaction between neutrons and ¹⁰B.

The desired thickness of the neutron detecting boron carbide layer may be less than about 4 µm, or, less than about 3 µm, or, less than about 2 µm, or, less than about 1.5 µm, or, less than about 1.3 µm, or, less than about 1.2 µm, or, less than about 1.1 µm.

The desired thickness of the neutron detecting boron carbide layer may be at least about 0.2 µm, or, at least about 0.4 µm, or, at least about 0.6 µm, or, at least about 0.8 µm or, at least about 0.9 µm, or at least about 1 µm.

The desired thickness of the neutron detecting boron carbide layer may be in a range of about 0.3 µm to about 1.8 µm, preferably in a range of about 0.5 µm to about 1.6 µm, more preferably in a rage of about 0.7 µm to about 1.3 µm, and most preferably in a range of about 0.9 µm to about 1.1 µm.

The neutron detecting boron carbide layer may be coated directly onto the coating surface of the substantially neutron transparent substrate.

The neutron detecting boron carbide layer may be coated onto an intermediate or gradient layer, such as an adhesion-promoting layer.

There may be one or more intermediate or gradient layers between the neutron detecting boron carbide layer and the substantially neutron transparent substrate. By use of an intermediate or gradient layer further improved adhesion may be possible.

The neutron detecting boron carbide layer may be a B₄C-layer.

B₄C-coatings can be made wear resistant with thermal and chemical stability. B₄C is here meant crystalline or amorphous compounds, or a combination thereof, consisting of B and C, where the B-content ranges between about 70% and 84% of the total number of B and C atoms, i.e. disregarding possible impurities. A lower carbon content would result in lower long-term stability of the coating, since a B-rich coating is more reactive. The higher the carbon content of the boron carbide coating comprising boron-10, the lower the neutron detection efficiency of the coating. By "detection efficiency" is here meant the number of detected neutrons in relation to how many neutrons that enter the neutron detecting boron carbide layer.

The at least one source of coating material may comprise boron-10 enriched B₄C (¹⁰B₄C).

The at least one source of coating material may preferably substantially consist of boron-10 enriched B₄C (¹⁰B₄C). Normally B is a mixture of 20% ¹⁰B and 80% ¹¹B. Enriched ¹⁰B₄C has in practice typically a ¹⁰B content of about 70 at.% to about 84 at.%. Instead of using ¹⁰B₄C as a single source of coating material, separate sources of ¹⁰B and C may be used during the coating.

A neutron detector component may be provided, that may be produced according to the method described above, for use in a neutron detector, the neutron detector component (1) comprising a neutron detecting boron carbide layer comprising boron-10 arranged on a substantially neutron transparent substrate, wherein the substantially neutron transparent substrate is a temperature sensitive substrate having a melting temperature that is at most about 660°C.

The substantially neutron transparent substrate may be electrically conducting.

The substantially neutron transparent substrate may comprise aluminum or aluminum alloys.

The neutron detecting boron carbide layer may be electrically conducting.

The neutron detecting boron carbide layer may have a thickness that is less than about 4 µm, or, less than about 3 µm, or, less than about 2 µm, or, less than about 1.5 µm, or, less than about 1.3 µm, or, less than about 1.2 µm, or, less than about 1.1 µm.

The neutron detecting boron carbide layer may have a thickness that is at least about 0.2 µm, or, at least about 0.4 µm, or, at least about 0.6 µm, or, at least about 0.8 µm or, at least about 0.9 µm, or at least about 1 µm.

The neutron detecting boron carbide layer may have a thickness that is in a range of about 0.3 µm to about 1.8 µm, preferably in a range of about 0.5 µm to about 1.6 µm, more preferably in a rage of about 0.7 µm to about 1.3 µm, and most preferably in a range of about 0.9 µm to about 1.1 µm.

The neutron detecting boron carbide layer may be coated directly onto the coating surface of the substantially neutron transparent substrate.

The neutron detecting boron carbide layer may be a B₄C-layer.

The boron-10 content of the neutron detecting boron carbide layer may be at least about 65 at.%, preferably at least about 70 at.%, more preferably at least about 75 at.%, and most preferably in the range of about 80 to about 100 at.%.

The neutron
detector component described above may be used for detecting neutrons.

A neutron detecting
device may comprise a plurality of neutron detector components arranged as a stack.

The number of neutron detector components in the stack may be at least 2, preferably at least 10, more preferably at least 15, even more preferably at least 20, and most preferably at least 25.

The more neutron detector components used, thus resulting in more neutron detecting layers, the more efficient neutron detection efficiency of the neutron detecting device. However, in practice the gain of more components may at some point be so small that it does not motivate the increased cost and complexity resulting from further components.

The detection efficiency of the neutron detecting device may be at least 30%, preferably at least 40%, more preferably at least 50%, even more preferably at least 60%, and most preferably at least 70% .

### Brief description of the drawings

The above, as well as other aspects, components and advantages of the present invention, will be better understood through the following illustrative and non-limited detailed description, with reference to the appended drawings.
Fig. 1 schematically shows a cross-sectional view of a neutron detector component according to a first embodiment.
Fig. 2 is a flow chart illustrating a method for producing a neutron detector component.
Fig. 3 schematically shows a substrate in a growth chamber, the substrate being specifically heated during production of the neutron detector component.
Fig. 4 shows a neutron detecting device with N number of detector components arranged as a stack.

In the drawings the same reference numerals may be used for same, similar or corresponding features, even when the reference numerals refer to features in different embodiments.

### Detailed description

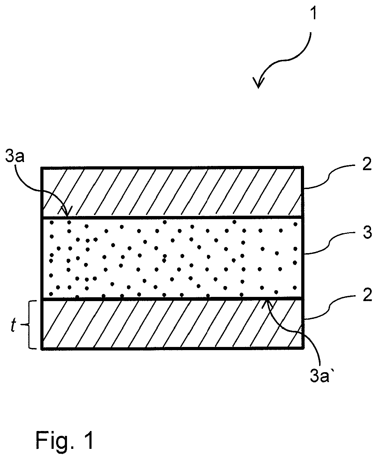

Fig.1 schematically shows a cross-sectional view of a neutron detector component 1 having as neutron detecting layers a respective boron carbide layer 2 comprising boron-10 (¹⁰B) of thickness t arranged on each one of opposing coating surfaces 3a, 3a' of a substantially neutron transparent substrate 3 that in one embodiment is made of aluminum. In other embodiments the neutron detecting boron carbide layer 2 may constitute only a sub-layer or sub-portion of a larger neutron detecting layer or neutron detecting stack of layers, for example one layer in a multi-layered neutron detecting stack. In some applications, such as for use in neutron detectors of e.g. multi-grid type, a two-sided coating of the shown type is an advantage. However, for other applications a one-sided coated substrate 3 may be desirable and thus in other embodiments there may be a neutron detecting layer 2 on only one side of the substrate 3. The neutron detector component may have different shapes, which typically is determined by the design of the neutron detector which the neutron detecting component 1 is to be used with. However, typically the component is sheet-shaped or in the form of a neutron detector plate or blade that may have a flat structure but may in other embodiments be curved. The component may also e.g. be of tubular shape or in the form of a wire.

The neutron detecting boron carbide layer 2 may, as in the shown embodiment of fig. 1, be arranged directly onto the substantially neutron transparent substrate 3. In other embodiments there may be one or many intermediate or gradient layers, such as a layer to promote adhesion between the substantially neutron transparent substrate 3 and the neutron detecting boron carbide layer 2. Such an adhesive layer may for example be a layer created in-situ by deposition from the same or a separate deposition source(s) as the neutron detecting boron carbide layer 2. Such an adhesion layer may be metallic or ceramic and have any chemical composition, including that of the substrate 3, the neutron detecting boron carbide layer 2, or of any other material of a larger neutron detecting layer comprising the neutron detecting boron carbide layer 2 as a sub-layer or sub-portion. The adhesion layer may also be created by in-situ surface modification induced by ion irradiation, electron irradiation, photon irradiation, or a combination thereof.

The thickness ,t, of the boron carbide layer 2 as neutron detecting layer is generally typically above 0.2 µm and below 4 µm, or below 3 µm, or below 2.5 µm, or below 2 µm, or below 1.5 µm, or below 1 µm. In one embodiment it is preferably in the range of 1 µm and 2 µm.

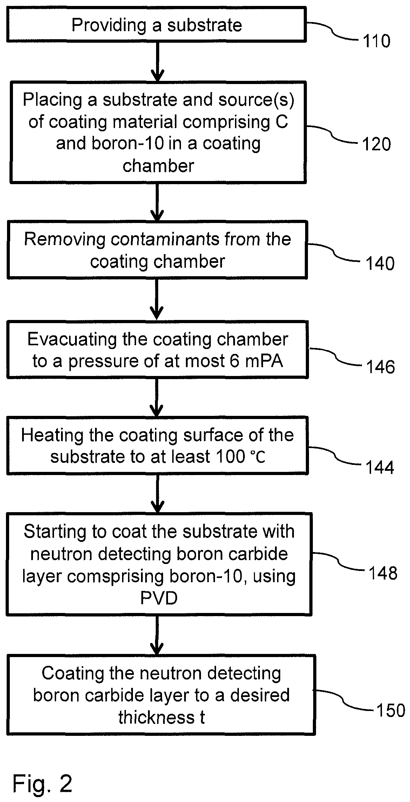

In the following an embodiment of a method for producing a neutron detector component 1 will be discussed with reference to a detailed embodiment, where the major steps of the method are shown in the flow chart in fig.2.

In a first step 110, the substantially neutron transparent substrate 3 is provided. In the detailed embodiment a 0.5 mm thick rolled aluminum (Al) blade from the alloy EN AW-5083 is used as the substantially neutron transparent substrate 3. In another embodiment an aluminum foil with a thickness below 0.1 mm may be used as the substantially neutron transparent substrate 3. In yet other embodiments, substrates 3 having thicknesses up to several millimeters may be used. In the detailed embodiment, the Al blade is cleaned in ultrasonic baths of Neutracon followed by de-ionized water and subsequently blown dry in dry N₂. In other embodiments, the substrate 3 may be cleaned by other means, including for example de-greasing in organic solvents and/or etching in an acid.

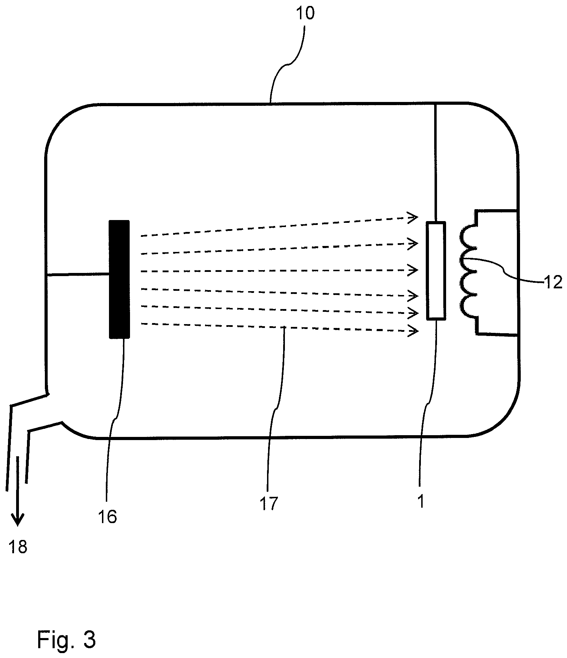

In a step 120 the substantially neutron transparent substrate 3 and source(s) of coating material 16 is placed inside a coating chamber of a deposition system, for example a coating chamber 10 as schematically illustrated in fig. 3. In the detailed embodiment, up to 24 Al blades (20 x 180 mm in size) are used as substrates 3 and mounted onto a sample carousel, which allows for 2-axis planetary rotation and 2-sided depositions, and placed in the coating chamber of an industrial CC800/9 deposition system (CemeCon AG, Germany).

In a step 146 the coating chamber 10 is being evacuated to a pressure that is at most 6 mPa and in a step 144 at least a coating surface 3a of the substantially neutron transparent substrate 3 is heated to an elevated temperature that is at least 100°C. Typically the whole substrate 3 is heated to this temperature, but it may be sufficient to heat only a coating surface 3a, 3a', that is, the surface of the substrate 3 to be coated. Steps 146 and 144 may be performed sequentially and/or partly of wholly simultaneously. When the pressure and elevated temperature has been reached, coating of the substantially neutron transparent substrate 3 with a neutron detecting boron carbide layer 2 starts in a step 148. The pressure is thus a pressure under the gas load resulting from the heating and is typically accomplished using a vacuum pumping system connected to the deposition system which comprises the coating chamber 10. This pressure may be termed base pressure, working pressure or steady-state pressure of the system. The gas load is the sum of the residual gas remaining from the initial atmosphere and the vapor pressure of the materials present in the coating chamber 10 and the leakage, outgassing, and permeation. This pressure should be low enough to provide a clean substrate 3 surface and reduced amount of contaminants in the boron carbide coating 2 during deposition, and is typically higher than the ultimate pressure of the vacuum pumping system.

To accomplish this pressure, the coating chamber 10 of the deposition system of the detailed embodiment may be evacuated at full pumping speed for 3 hours for reaching a base pressure of 0.25 mPa in the coating chamber 10 prior to deposition. Pressures up to 6 mPa may be used in other embodiments. In yet other embodiments pressures lower than 0.25 mPa may be used. Generally, the lower said pressure is, before and during the deposition, the better.

In a step 150, the neutron detecting boron carbide layer 2 comprising boron-10 is being coated on the substantially neutron transparent substrate 3 by means of physical vapor deposition (PVD). The substrate 3 is preferably continued to be heated also during this step 150. If the PVD method used involves a working gas, e.g. Ar, the pressure will increase; however, preferably the partial pressure of contaminants is kept at corresponding low levels when starting step 150. In the detailed embodiment the Ar partial pressure is kept at about 0.8 Pa. In fig. 3 the schematic arrows 17 represent the evaporation direction of evaporated material from the source of coating material 16 to the substrate 3 during the step of coating 150. The PVD method may, as in the detailed embodiment, be dc magnetron sputtering. In other embodiments other sputtering techniques may be used such as rf magnetron sputtering, high-impulse magnetron sputtering, ion-beam sputtering, reactive sputtering, ion-assisted deposition, high-target-utilization sputtering or gas flow sputtering. In yet other embodiments, the PVD technique that may be used in step 150 may instead of magnetron sputtering techniques be other PVD techniques, such as cathodic arc deposition, electron beam physical vapor deposition, evaporative deposition or pulsed laser deposition. The heating temperature at the Al blades is kept at 400°C ion the detailed embodiment. In other embodiments temperatures of at least 100°C, 200°C, 300°C, 500°C or 600°C may be used. It is also possible to vary the temperature of the substantially neutron transparent substrate 3 during the step of coating 150. In the detailed embodiment the heating of the substrate 3 is accomplished by indirect heating, more particularly by irradiating the substrate 3 with infrared radiation supplied by a resistive heating element inside the coating chamber 10, corresponding to what is illustrated by heating element 12 in fig. 3.

In the detailed embodiment, four ¹⁰B₄C sputtering targets, bonded to Cu-components, are used as sources of coating material 16. The sputtering targets 16 are operated in dc mode and the maximum applied power is 4000 W to each magnetron. A fewer number of targets 16 may be used and the power applied to each magnetron may range from 1500 W to 4000 W. In other embodiments more sputtering targets 16 and/or higher applied power to each magnetron may be used. In an alternative embodiment separate sputtering targets 16 of ¹⁰B and C may be used instead of ¹⁰B₄C.

An increased film growth rate may be achieved during the coating step 150 by increasing the number of sputtering targets 16 and/or the applied power to each magnetron. Also, the type of coating system used may have an effect on the growth rate. It may be advantageous to use as high growth rate as possibly allowed by the PVD deposition system used. For example may a high growth rate enable use of less clean working gases during the coating of the boron carbide layer 2, i.e. a working gas with a higher partial pressure of contaminants in the working gas, and still accomplish a boron carbide layer 2 with low levels of contaminants. However, generally it is of course advantageous with as clean working gases as possible. Typical and possible growth rates may be in the range of 0.1 to 500 pm/h. In a step 140, contaminants are removed from the coating chamber 10. The removal of contaminants 140 may be a separate step performed prior to and/or partly fully simultaneously with steps 144 and 146. For example, in the detailed embodiment, heating and degassing of the coating chamber 10 containing the Al blades as substrates 3 and the source(s) of coating material 16 is performed during steps 144 and 146 using heat from the heating of the substrate 3. For example, the degassing may be performed at chamber temperatures up to 500 °C, or even higher. However, more generally, temperatures of at least about 300°C are often sufficient for removal of most contaminants in step 140, although there is removal of contaminants also at temperatures of about 100°C. Different contaminants leave a surface at different temperatures. At 300°C most water molecules is believed to have desorbed from the coating chamber 10, the substantially neutron transparent substrate 3 and the source(s) of coating material 16. H₂O contaminants may, in an alternative embodiment, be removed using a method directed at specifically removing water contaminants such as electron beam, infrared radiation, ultraviolet light and visible light irradiation, and ion irradiation or a combination of any of these methods. In yet an alternative embodiment, a method directed at specifically removing water contaminants may be combined with preheating and degassing in the step of removing contaminants 140. If the time cycling of the step of removing contaminants 140 is very short, desorption of water vapor, by for example using ultraviolet light irradiation, may be a faster process for removing H₂O contaminants than using heating and degassing.

Combining an efficient removal of contaminants in the step of removing contaminants 140 with a high temperature at the substantially neutron transparent substrate 3 during the coating step 150 and a high growth rate may result in a low amount of impurities in the neutron detecting boron carbide layer 2. In the detailed embodiment, neutron detecting boron carbide layers 2 are deposited at a temperature of 400°C at the Al blades 3 using four sputtering ¹⁰B₄C targets 16 and an applied power of 4000 W to each magnetron. Under these conditions the resulting neutron detecting boron carbide layers 2 may have an amount of impurities of 5.6 at.% and the ¹⁰B content may be as much as 77 at.%.

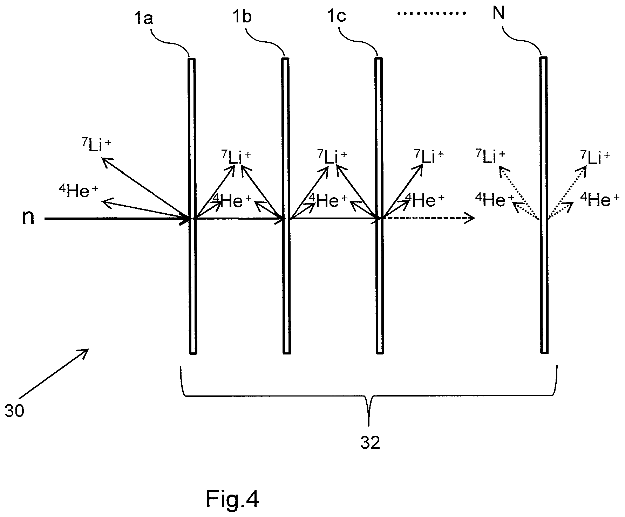

Fig. 4 shows a neutron detecting device 30 with N number of neutron detector components 1a, 1b, 1c, N arranged as a stack 32. Each neutron detector component 1a,1b,1c,N may be a neutron detector component as discussed above and may be produced according to the method discussed above. The number of detector components 1a, 1b, 1c,N may vary between embodiments. In general, the higher the number of detector components 1a, 1b, 1c,N in the stack 32, the higher is the neutron detection efficiency of the neutron detecting device 30. However, the detection efficiency also depends on the thickness t of the neutron detecting boron carbide layer 2, the neutron wavelength, and the amount of impurities in the boron carbide layer 2. The distance between detector components 1a, 1b, 1c,N in the stack 32 in the neutron detecting device 30 is in one embodiment about 2 cm. In other embodiments the distance between components 1a, 1b, 1c,N in the stack 32 may be up to 10 cm. In yet another embodiment the distance between the components 1a,1b,1c,N may be in the millimeter range.

Instead of using separate neutron detector components 1a, 1b, 1c,N in the stack 32, the neutron detecting device 30 may comprise a folded neutron detector component 1, which through the folding forms a stack 32 with several neutron detecting boron carbide layers 2 from only one neutron detector component 1, instead of from several separate components 1a,1b,1c,N.

In one embodiment 15 detector components 1a,1b, 1c,N with neutron detecting boron carbide layers 2 coated on opposing surfaces 3a, 3a' of respective substrate 3 are used in stack 32 of the neutron detecting device 30, resulting in 30 neutron detecting boron carbide layers 1a,1b,2c,N in the stack 32. In other embodiments up to 25 two-sided coated detector components 1a, 1b, 1c,N may be used. A full-scale large area neutron detecting device 30 is in one embodiment designed to cover an active surface area of about 30 m², which corresponds to about 1000 m² of ¹⁰B-containing neutron detecting boron carbide layers 2.

In one embodiment of the neutron detecting device 30, 15 neutron detector components 1a,1b,1c,N are used in the stack 32, each neutron detector component 1a,1b,1c,N having a boron carbide layer thickness t of 1 µm. This may result in a neutron detecting device 30 having a detection efficiency of about 67%. The same setup as above but with a neutron detecting boron carbide layer thickness t of 2 µm results in a lower detection efficiency. Too thick neutron detecting layers 2 lowers the probability that the ⁷Li and ⁴He isotopes, formed in the nuclear reaction between a neutron and ¹⁰B, can escape from the boron carbide layer 2 and be detected.

In yet another embodiment, 25 detector components 1a, 1b, 1c,N with 1 µm thick coatings 2 are used in the stack 32, leading to a detection efficiency approaching a maximum of about 71 %.

Small changes in the wavelength of the incoming neutron do not affect the detection efficiency of the neutron detecting device 30 to a large extent, but for an optimized neutron detecting device 30, the number of detector components 1a, 1b, 1c,N (i.e. the number of neutron detecting layers 2) and the thickness ,t, of the neutron detecting layers 2 should be adjusted to the wavelength of current interest.

Any illustration and description in the drawings and in the foregoing description are to be considered exemplary and not restrictive. The invention is not limited to the disclosed embodiments. On the contrary, many modifications and variations are possible within the scope of the appended claims in addition to those already discussed. For example, the neutron detecting boron carbide layer 2 may consist of a composition gradient. The neutron detector component 1 may be composed of several layers of neutron transparent layers and neutron detecting boron carbide layers 2 forming bilayers, tri-layers or more generally multi-layers. The present invention is defined by the claims and variations to the disclosed embodiments and can be understood and effected by the person skilled in the art in practicing the claimed invention, for example by studying the drawings, the disclosure, and the claims. Use of the word "comprising" in the claims does not exclude other elements or steps, and use of the article "a" or "an" does not exclude a plurality. Occurrence of features in different dependent claims does not per se exclude a combination of these features. Any method claim is not to be construed as limited merely because of the presentational order of the steps. Any possible combination between independent steps of any method claim shall be construed as being within scope, although the independent steps, by necessity must, occur in some presentational order. Any reference signs in the claims are for increased intelligibility and shall not be construed as limiting the scope of the claims.

## Claims

1. Method for producing a neutron detector component (1) comprising a neutron detecting boron carbide layer (2) comprising boron-10 arranged on a substantially neutron transparent substrate (3), the method comprising:
- placing (120) the substantially neutron transparent substrate (3) and at least one source of coating material (16) comprising carbon and boron-10 inside a coating chamber (10);
- evacuating (146) the coating chamber (10) to a pressure that is at most 6 mPa and heating (144) at least a coating surface (3a) of the substantially neutron transparent substrate (3) in the coating chamber (10) to an elevated temperature that is at least 300°C to 660°C;
- starting (148) to coat the neutron detecting boron carbide layer (2) comprising boron-10 on the substantially neutron transparent substrate (3) by means of physical vapor deposition in the form of magnetron sputtering using the at least one source of coating material (16) when said pressure and said elevated temperature are reached; and
- coating (150) the neutron detecting boron carbide layer (2) comprising boron-10 to a desired thickness (t), wherein the boron content ranges between 70 at.% and 84 at.% of the total number of boron and carbon atoms in the boron carbide layer (2), disregarding impurities, and the rest being carbon atoms, and wherein the boron-10 content of the neutron detecting boron carbide layer (2) is at least 60 at.% of the boron atoms in the boron carbide layer (2).

2. The method as claimed in claim 1, further comprising heating of at least a coating surface (3a) of the substantially neutron transparent substrate (3) during the coating (150) of the neutron detecting boron carbide layer (2) and preferably comprising heating to at least said elevated temperature.

3. The method as claimed in any one of the preceding claims, further comprising:
- removing (140) contaminants from the coating chamber (10) with the substantially neutron transparent substrate (3) and the source of coating material (16) placed inside, prior to and/or during the evacuating (146) of the coating chamber (10).

4. The method as claimed in claim 3, wherein removing contaminants (140) from the coating chamber (10) comprises heating and degassing of the coating chamber (10), while keeping the temperature of the substantially neutron transparent substrate (3) below its melting temperature.

5. The method as claimed in claim 4, wherein the heating of the coating chamber (10) comprises using heat from the heating (144) of at least a coating surface (3a) of the substantially neutron transparent substrate (3).

6. The method as claimed in any one of claims 4-5, wherein the heating of the coating chamber (10) comprises using another separate source of heat than is used for the heating (144) of at least a coating surface (3a) of the substantially neutron transparent substrate (3).

7. The method as claimed in any one of claims 4-6, wherein the heating of the coating chamber (10) comprises heating thereof to at least 100°C, or at least 200°C, or at least 300°C, or at least 400°C, or at least 500°C, or at least 600°C.

8. The method as claimed in any one of claims 3-7, wherein the removing of contaminants (140) from the coating chamber (10) includes removal of H₂O contaminants, preferably using a method directed specifically at reducing H₂O contaminants and is selected from the group consisting of electron beam, infrared radiation, ultraviolet light and visible light irradiation, ion irradiation, contact with a resistive heating element, or a combination of any of these methods.

9. The method as claimed in any one of the preceding claims, wherein the coating chamber (10) is evacuated to a pressure that is at most 3 mPa, preferably at most 1.5 mPa, or more preferably at most 0.75 mPa.

10. The method as claimed in any one of the preceding claims, comprising coating of the substantially neutron transparent substrate (3) on opposing coating surfaces (3a, 3a').

11. The method as claimed in any one of the preceding claims, wherein the neutron detecting boron carbide layer (2) is being coated directly onto the coating surface (3a) of the substantially neutron transparent substrate (3).

12. The method as claimed in any one of claims 1-10, wherein the neutron detecting boron carbide layer (2) is being coated onto an intermediate or gradient layer, such as an adhesion-promoting layer.

## Patentansprüche

1. Verfahren zum Herstellen eines Neutronendetektorbauelements (1), eine Neutronen detektierende Borcarbidschicht (2) umfassend, welche Bor-10 umfasst, welches auf einem im Wesentlichen für Neutronen durchsichtigen Substrat (3) angeordnet ist, das Verfahren Folgendes umfassend:
- Platzieren (120) des im Wesentlichen für Neutronen durchsichtigen Substrats (3) und mindestens einer Quelle von Beschichtungsmaterial (16), welche Kohlenstoff und Bor-10 umfasst, in einer Beschichtungskammer (10);
- Evakuieren (146) der Beschichtungskammer (10) auf einen Druck, welcher höchstens 6 mPa beträgt, und Erhitzen (144) der mindestens einen Beschichtungsoberfläche (3a) des im Wesentlichen für Neutronen durchsichtigen Substrats (3) in der Beschichtungskammer (10) auf eine erhöhte Temperatur, die mindestens 300 °C bis 660 °C beträgt;
- Anfangen (148) die Neutronen detektierende Borcarbidschicht (2), welche Bor-10 umfasst, auf dem im Wesentlichen für Neutronen durchsichtigen Substrat (3) mittels physikalischer Dampfabscheidung in der Form von Magnetronzerstäubung unter Verwendung der mindestens einen Quelle des Beschichtungsmaterials (16) zu beschichten, wenn der Druck und die erhöhte Temperatur erreicht sind; und
- Beschichten (150) der Neutronen detektierenden Borcarbidschicht (2), die Bor-10 umfasst, auf eine erwünschte Dicke (t), wobei der Borgehalt in dem Bereich zwischen 70 Atom-% und 84 Atom-% der Gesamtzahl von Bor- und Kohlenstoffatomen in der Borcarbidschicht (2), ohne Berücksichtigung von Fremdstoffen, liegt und der Rest Kohlenstoffatome sind und wobei der Bor-10-Gehalt der Neutronen detektierenden Borcarbidschicht (2) mindestens 60 Atom-% der Boratome in der Borcarbidschicht (2) beträgt.

2. Verfahren nach Anspruch 1, weiterhin Erhitzen mindestens einer Beschichtungsoberfläche (3a) des im Wesentlichen für Neutronen durchsichtigen Substrats (3) während des Beschichtens (150) der Neutronen detektierenden Borcarbidschicht (2) umfassend und vorzugsweise Erhitzen mindestens auf die erhöhte Temperatur umfassend.

3. Verfahren nach einem der vorhergehenden Ansprüche, weiterhin Folgendes umfassend:
- Entfernen (140) von Verunreinigungen aus der
Beschichtungskammer (10), innerhalb welcher das im Wesentlichen für Neutronen durchsichtigen Substrat (3) und die Quelle des Beschichtungsmaterials (16) angeordnet sind, vor und/oder während des Evakuierens (146) der Beschichtungskammer (10).

4. Verfahren nach Anspruch 3, wobei Entfernen von Verunreinigungen (140) aus der Beschichtungskammer (10) Erhitzen und Entgasen der Beschichtungskammer (10) umfasst, während die Temperatur des im Wesentlichen für Neutronen durchsichtigen Substrats (3) unter seiner Schmelztemperatur gehalten wird.

5. Verfahren nach Anspruch 4, wobei das Erhitzen der Beschichtungskammer (10) Verwenden von Wärme von dem Erhitzen (144) der mindestens einen Beschichtungsoberfläche (3a) des im Wesentlichen für Neutronen durchsichtigen Substrats (3) umfasst.

6. Verfahren nach einem der Ansprüche 4 bis 5, wobei das Erhitzen der Beschichtungskammer (10) Verwenden einer anderen separaten Wärmequelle als die umfasst, welche zum Erhitzen (144) der mindestens einen Beschichtungsoberfläche (3a) des im Wesentlichen für Neutronen durchsichtigen Substrats (3) verwendet wird.

7. Verfahren nach einem der Ansprüche 4 bis 6, wobei das Erhitzen der Beschichtungskammer (10) Erhitzen von dieser auf mindestens 100 °C oder mindestens 200 °C oder mindestens 300 °C oder mindestens 400 °C oder mindestens 500 °C oder mindestens 600 °C umfasst.

8. Verfahren nach einem der Ansprüche 3 bis 7, wobei das Entfernen von Verunreinigungen (140) aus der Beschichtungskammer (10) Entfernung von H₂O-Verunreinigungen umfasst, vorzugsweise unter Verwendung eines Verfahrens, welches spezifisch auf ein Reduzieren von H₂O-Verunreinigungen gerichtet ist und aus der Gruppe ausgewählt ist, bestehend aus Bestrahlung mit Elektronenstrahl, Infrarotstrahlung, Ultraviolettlicht und sichtbarem Licht, lonenbestrahlung, Kontakt mit einem Widerstandsheizelement oder einer Kombination aus beliebigen dieser Verfahren.

9. Verfahren nach einem der vorhergehenden Ansprüche, wobei die Beschichtungskammer (10) auf einen Druck evakuiert wird, der höchstens 3 mPa, vorzugsweise höchstens 1,5 mPa oder besonders bevorzugt höchstens 0,75 mPa beträgt.

10. Verfahren nach einem der vorhergehenden Ansprüche, Beschichten des im Wesentlichen für Neutronen durchsichtigen Substrats (3) auf einander gegenüberliegenden Beschichtungsoberflächen (3a, 3a') umfassend.

11. Verfahren nach einem der vorhergehenden Ansprüche, wobei die Neutronen detektierende Borcarbidschicht (2) unmittelbar auf der Beschichtungsoberfläche (3a) des im Wesentlichen für Neutronen durchsichtigen Substrats (3) beschichtet wird.

12. Verfahren nach einem der Ansprüche 1 bis 10, wobei die Neutronen detektierende Borcarbidschicht (2) auf einer Zwischen- oder Gradientenschicht, wie beispielsweise einer Haftschicht, beschichtet wird.

## Revendications

1. Procédé de production d'un composant détecteur de neutrons (1) comprenant une couche de carbure de bore de détection de neutrons (2) comprenant du bore-10 agencé sur un substrat sensiblement transparent aux neutrons (3), le procédé comprenant :
- le placement (120) du substrat sensiblement transparent aux neutrons (3) et d'au moins une source de matériau d'enduction (16) comprenant du carbone et du bore-10 à l'intérieur d'une chambre d'enduction (10) ;
- l'évacuation (146) de la chambre d'enduction (10) à une pression qui est au plus 6 mPa et le chauffage (144) d'au moins une surface d'enduction (3a) du substrat sensiblement transparent aux neutrons (3) dans la chambre d'enduction (10) à une température élevée qui est au moins de 300 °C à 660 °C ;
- le commencement (148) de l'enduction de la couche de carbure de bore de détection de neutrons (2) comprenant du bore-10 sur le substrat sensiblement transparent aux neutrons (3) au moyen d'un dépôt physique en phase vapeur sous la forme d'une pulvérisation à magnétron en utilisant l'au moins une source de matériau d'enduction (16) lorsque ladite pression et ladite température élevée sont atteintes ; et
- l'enduction (150) de la couche de carbure de bore de détection de neutrons (2) comprenant du bore-10 à une épaisseur (t) souhaitée, dans lequel la teneur en bore est dans une plage entre 70 % atomique et 84 % atomique du nombre total d'atomes de bore et de carbone dans la couche de carbure de bore (2), sans tenir compte d'impuretés, et le reste étant des atomes de carbone, et dans lequel la teneur en bore-10 de la couche de carbure de bore de détection de neutrons (2) est au moins 60 % atomique des atomes de bore dans la couche de carbure de bore (2).

2. Procédé selon la revendication 1, comprenant en outre le chauffage d'au moins une surface d'enduction (3a) du substrat sensiblement transparent aux neutrons (3) au cours de l'enduction (150) de la couche de carbure de bore de détection de neutrons (2) et de préférence comprenant le chauffage au moins à ladite température élevée.

3. Procédé selon l'une quelconque des revendications précédentes, comprenant en outre :
- la suppression (140) de contaminants de la chambre d'enduction (10) avec le substrat sensiblement transparent aux neutrons (3) et la source de matériau d'enduction (16) placés à l'intérieur de celle-ci, avant et/ou pendant l'évacuation (146) de la chambre d'enduction (10).

4. Procédé selon la revendication 3, dans lequel la suppression de contaminants (140) de la chambre d'enduction (10) comprend le chauffage et le dégazage de la chambre d'enduction (10), tout en maintenant la température du substrat sensiblement transparent aux neutrons (3) au-dessous de sa température de fusion.

5. Procédé selon la revendication 4, dans lequel le chauffage de la chambre d'enduction (10) comprend l'utilisation d'une chaleur du chauffage (144) d'au moins une surface d'enduction (3a) du substrat sensiblement transparent aux neutrons (3).

6. Procédé selon la revendication 4 ou 5, dans lequel le chauffage de la chambre d'enduction (10) comprend l'utilisation d'une source distincte de chaleur autre que celle utilisée pour le chauffage (144) d'au moins une surface d'enduction (3a) du substrat sensiblement transparent aux neutrons (3).

7. Procédé selon l'une quelconque des revendications 4 à 6, dans lequel le chauffage de la chambre d'enduction (10) comprend le chauffage de celle-ci à au moins 100 °C, ou au moins 200 °C, ou au moins 300 °C, ou au moins 400 °C, ou au moins 500 °C, ou au moins 600 °C.

8. Procédé selon l'une quelconque des revendications 3 à 7, dans lequel la suppression de contaminants (140) de la chambre d'enduction (10) inclut la suppression de contaminants H₂O, de préférence l'utilisation d'un procédé spécifiquement destiné à réduire des contaminants H₂O et sélectionné dans le groupe se composant de: faisceau d'électrons, rayonnement infrarouge, rayonnement de lumière ultraviolette et de lumière visible, rayonnement ionique, contact avec un élément chauffant résistif, ou une combinaison de procédés quelconques parmi ceux-ci.

9. Procédé selon l'une quelconque des revendications précédentes, dans lequel la chambre d'enduction (10) est évacuée à une pression qui est au plus 3 mPa, de préférence au plus 1,5 mPa, ou avec plus de préférence au plus 0,75 mPa.

10. Procédé selon l'une quelconque des revendications précédentes, comprenant l'enduction du substrat sensiblement transparent aux neutrons (3) sur des surfaces d'enduction (3a, 3a') opposées.

11. Procédé selon l'une quelconque des revendications précédentes, dans lequel la couche de carbure de bore de détection de neutrons (2) est enduite directement sur la surface d'enduction (3a) du substrat sensiblement transparent aux neutrons (3).

12. Procédé selon l'une quelconque des revendications 1 à 10, dans lequel la couche de carbure de bore de détection de neutrons (2) est enduite sur une couche intermédiaire ou à gradient, telle qu'une couche favorisant l'adhérence.
